# EUROPÄISCHE PATENTSCHRIFT

(11) **EP 3 599 480 B1**
(45) Veröffentlichungstag und Bekanntmachung des Hinweises auf die Patenterteilung: **07.09.2022**
(21) Anmeldenummer: 19187553.3
(22) Anmeldetag: 22.07.2019
(51) Int. Cl.: G01S 7/481, B60H 1/26

(54) **LÜFTER MIT INTEGRIERTEM SENSOR**
VENTILATOR WITH INTEGRATED SENSOR
VENTILATEUR POURVU DE CAPTEUR INTÉGRÉ

(30) Priorität: 25.07.2018 DE 102018118007
(43) Veröffentlichungstag der Anmeldung: 29.01.2020
(73) Patentinhaber: Deutsche Post AG, 53113 Bonn (DE)
(72) Erfinder: Augspurger, Tobias, 52066 Aachen (DE); Orth, Felix, 52066 Aachen (DE); Ening, Klaus, 52070 Aachen (DE); Turan, Bugra, 52072 Aachen (DE); Fiege, Nick, 52070 Aachen (DE)
(74) Vertreter: Michalski Hüttermann & Partner Patentanwälte mbB

(56) Entgegenhaltungen:
- DE-A1-102016 201 057
- US-A1- 2018 109 061

## Beschreibung

### Technisches Gebiet

Die Erfindung betrifft ein Fahrzeug mit einem drehbar gelagerten Sensor, eingerichtet ein Abbild einer Umgebung des Fahrzeugs zu erstellen, und einer Steuerungseinrichtung, eingerichtet von dem Sensor erhaltene Daten zu verarbeiten. Die Erfindung betrifft ein Verfahren zum Erstellen eines Abbilds einer Umgebung eines Fahrzeugs, mit dem Schritt Drehen eines Laufrads einer Ventilationseinrichtung, eingerichtet eine Steuerungseinrichtung des Fahrzeugs zu kühlen.

### Hintergrund der Erfindung

Infolge steigenden Güterverkehrs durch Stück- und Sammelgutfahrten, LKW- oder Containertransporte, See- oder Luftfrachtpakettransporte im Rahmen von E-Commerce und Online-Versandhandelsangeboten hat sich die Anzahl an Transportgütern und insbesondere von Paketsendungen, Sendungen oder sonstigen transportablen Gütern, nachfolgend allgemein als Objekte bezeichnet, signifikant erhöht. Zwar ist es heutzutage möglich, eine Bestellung unabhängig von herkömmlichen Ladenöffnungszeiten Online zu tätigen, jedoch erfolgt die Lieferung des Objektes an den Empfänger fast ausschließlich mittels klassischer Zustellverfahren, beispielsweise durch Briefträger oder im Falle von Paketsendungen durch motorisierte Zustellfahrzeuge und im Wesentlichen nur innerhalb der Ladenöffnungszeiten. Ist der Empfänger bei der Lieferung des Objektes nicht anzutreffen, beispielsweise weil er als Berufstätiger innerhalb der Zustellzeiten seiner Arbeit nachgeht, wird entweder versucht, das Objekt ein weiteres Mal zuzustellen oder das Objekt wird in einer Filiale des Zustellunternehmens, in einer Packstation, in einem Paketkasten, bei einem Nachbarn oder dergleichen zur späteren Abholung durch den Empfänger hinterlegt.

In jüngster Zeit sind daher Versuche unternommen worden, Objekte mittels unbemannter, autonomer Fahrzeuge an den Empfänger oder an eine Fachanlagenvorrichtung als Sammelpunkt zu liefern, beispielsweise an eine Packstation, welche im öffentlichen Raum für einen Stadtbezirk für eine Mehrzahl Empfänger oder im Vorgarten eines Hauses des Empfängers aufgestellt ist. Das Objekt kann außerhalb der Ladenöffnungs- oder Zustellzeiten aus der Fachanlagenvorrichtung entnommen oder in diese eingestellt werden.

Autonome Fahrzeuge verwenden Sensoren, insbesondere Lidar-Sensoren, um ein Abbild einer Umgebung des Fahrzeugs zu erstellen, anhand dessen sich das Fahrzeug autonom entlang einer vorgegebenen oder dynamisch erstellten Route fortbewegt. Derartige Lidar-Sensoren stellen ein zentrales Element für die autonome Fortbewegung dar, da die Sensoren solide Volumendaten unabhängig von umgebenden Lichtbedingungen liefern. Trotz fortschreitender Verbreitung autonomer Fahrzeuge sind Lidar Sensoren, insbesondere dreidimensionale, 3D, Lidar-Sensoren noch immer kostenaufwendig.

Die DE 10 2016 201 057 A1 beschreibt ein Fahrzeug mit einer Lidarvorrichtung zum Erfassen eines Objekts. Die Lidarvorrichtung umfasst eine um eine Drehachse herum drehbaren optischen Einrichtung, welche eine Vielzahl von ersten optischen Elementen und eine Vielzahl von zweiten optischen Elementen aufweist; eine Sendeeinrichtung zum Aussenden von Laserlichtstrahlen; und eine Empfangsreinrichtung zum Empfangen von reflektierten Laserlichtstrahlen; wobei die optische Einrichtung derart ausgebildet ist, dass bei Drehung der optischen Einrichtung um die Drehachse Laserlichtstrahlen mittels der Sendeeinrichtung durch jeweils ein optisches Element der Vielzahl von ersten optischen Elementen hindurch ausgesendet werden, und die an dem Objekt reflektierten Laserlichtstrahlen nach dem Durchgang durch ein optisches Element der Vielzahl von zweiten optischen Elementen von der Empfangseinrichtung empfangen werden. Im Zusammenhang mit (halb-)autonomem Fahren ist weiterhin ein Fahrerassistenzsystem erwähnt.

Die US 2018/0109061 A1 beschreibt ein autonom fahrendes Fahrzeug mit einer Lidarvorrichtung.

### Beschreibung der Erfindung

Ausgehend von dieser Situation ist es eine Aufgabe der vorliegenden Erfindung, ein Fahrzeug mit einem Sensor zum Erstellen eines Abbilds einer Umgebung des Fahrzeugs anzugeben, welcher im Vergleich zu aus dem Stand der Technik bekannten Sensoren günstiger herstellbar ist.

Die Aufgabe der Erfindung wird durch die Merkmale der unabhängigen Ansprüche gelöst. Vorteilhafte Ausgestaltungen sind in den Unteransprüchen angegeben.

Demnach wird die Aufgabe gelöst durch ein Fahrzeug gemäß des Anspruchs 1.

Dabei ist die Steuerungseinrichtung eingerichtet, das Fahrzeug autonom fortzubewegen, anhand von dem Sensor erhaltenen Umgebungsdaten das Abbild der Umgebung zu berechnen und/oder das Fahrzeug in Abhängigkeit des erstellten Abbilds autonom fortzubewegen. Die Steuerungseinrichtung kann also einerseits von dem Sensor erhaltene Daten verarbeiten, beispielsweise um eine elektronische Karte der Umgebung zu erstellen, oder das Fahrzeug insbesondere anhand der erstellten elektronische Karte autonom fortzubewegen. In jeden Fall ist für derartige Steuerungs- und/oder Rechenaufgaben regelmäßig eine hohe Rechenleistungen notwendig, die Abwärme generiert.

Ein wesentlicher Aspekt liegt darin, dass der Sensor, insbesondere ein Lidar-Sensor, drehbewegungsgekoppelt mit dem Laufrad ist. Sofern nun ein 2D-Lidar als Sensor verwendet wird, bewirkt die Drehbewegungskopplung, dass ein dreidimensionales Abbild der Umgebung des Fahrzeugs erfassbar ist. Die durch die Ventilationseinrichtung ohnehin für das Laufrad zwecks Kühlung der Steuerungseinrichtung erzeugte Drehbewegung wird durch die Drehbewegungskopplung auf den Sensor übertragen, so dass sich dieser um die Drehachse mitdreht. Sofern nun beispielsweise ein 2D-Lidar Sensor orthogonal verschwenkt als Sensor vorgesehen ist, kann durch die vorgeschlagene Vorrichtung in einfacher Weise das dreidimensionale Abbild der Umgebung des Fahrzeugs erfasst werden, da der 2D-Lidar Sensor durch die Drehbewegung dreidimensionale Volumendaten der Umgebung des Fahrzeugs liefern kann. Da Laufräder und Lidar-Sensoren autonomer Fahrzeuge sich oftmals mit gleicher Drehzahl von beispielsweise 5 bis 10 Umdrehungen pro Minute drehen, bietet sich wie vorgeschlagen an, Laufrad und Sensor miteinander zu koppeln, um die Drehbewegung des Laufrads auf den Sensor zu übertragen. Allerdings beschreitet das vorgeschlagene Fahrzeug einen ganz neuen Weg, da im Stand der Technik Sensoren, insbesondere Lidar-Sensoren, und Ventilationseinrichtungen autonomer Fahrzeuge immer separat und gerade nicht bewegungsgekoppelt ausgestaltet sind.

Das Fahrzeug kann in unterschiedlicher Weise ausgestaltet sein, wobei ebenso ein Personenkraftwagen, abgekürzt PKW, ein Lieferwagen, ein Robotor-Rollwagen, ein Kommissionierwagen oder ein Lastkraftwagen mit umfasst ist. Bevorzugt weist das Fahrzeug eine Fahrerkabine auf, hinter der ein Laderaum oder eine Ladefläche zum Transportieren von Objekten angeordnet ist. Das Fahrzeug ist bevorzugt als Zustellfahrzeug ausgeführt, um Objekte beispielweise zwischen einem Logistikzentrum, "Warehouse", Lager und/oder Verteilzentrum und Empfängern bzw. Absendern der Objekte zu überbringen. Bei den Empfängern bzw. Absendern der Objekte kann es sich um Personen, Packstationen und/oder vorgenannte Logistikzentren, "Warehouses", Lager oder Verteilzentren handeln. Das Fahrzeug kann neben einer bevorzugten autonomen Fahrweise ebenso personifiziert durch einen Zusteller entlang einer vorgegebenen oder selbst zusammengestellten Wegstrecke eingesetzt werden, um die Objekte an einen oder mehrere Zielorte zu überbringen und/oder an diesen aufzunehmen. Grundsätzlich jedoch kann das Fahrzeug bevorzugt autonom eine vorgegebene oder selbst zusammengestreckte Wegstrecke zurücklegen und selbstständig an einem oder mehreren Zielorten anhalten, an denen ein Objekt aus dem Laderaum entnehmbar ist und/oder in diesem abstellbar ist.

Der Laderaum kann als offene Ladefläche mit seitlichen, vorderen und/oder hinteren Türen und/oder Klappen ausgeführt sein. Besonders bevorzugt ist der Laderaum mittels der Türen gegen äußere Einflüsse insbesondere Witterungseinflüsse vollständig verschließbar, so dass unberechtigte Dritte keinen Zugriff auf die in dem Laderaum transportierten Objekte haben. Weiter bevorzugt weist der Laderaum ein quaderartiges Volumen auf und/oder ist der Laderaum mit einer rechteckigen Grundfläche als Ladefläche und/oder Boden versehen, auf dem die Objekte nebeneinander und/oder übereinander abstellbar sind. Das Nutzvolumen des Laderaums kann beispielsweise ≥ 4, ≥ 8, oder ≥ 20 m³ betragen, so dass als Nutzlast Objekte mit einem Gewicht von beispielsweise 650 kg, 1000 kg oder 1350 kg transportierbar sind. Der Laderaum weist bevorzugt eine rechteckige und/oder ebene Nutzfläche auf, auf der die Objekte aufnehmbar, insbesondere stapelbar sind.

Bei dem Objekt kann es sich um einen beliebigen transportablen Gegenstand handeln, insbesondere um eine Ware, ein Stückgut und/oder eine Sendung. Das Objekt kann Gegenstände des täglichen Bedarfs, wie beispielsweise Verbrauchsmaterialien oder Lebensmittel sowie technische Gegenstände oder Gerätschaften umfassen. Ebenso können Sendungen wie beispielsweise Briefsendungen, Paketsendungen und/oder Print-Produkte wie Prospekte, Broschüren oder Zeitschriften umfasst sein. Die Steuerungseinrichtung umfasst bevorzugt einen Rechner und/oder Computer, der mit einer Software versehen ist, um anhand von von dem Sensor erhaltenen Umgebungsdaten das Fahrzeug zu manövrieren. Die Drehachse erstreckt sich bevorzugt in Richtung der Flächennormalen der Ladefläche. Der Begriff drehbewegungsgekoppelt meint entweder eine starre Verbindung oder eine Verbindung derart, dass sich der Sensor auch unabhängig von dem Laufrad drehen kann, beispielsweise schneller als das Laufrad drehen kann, jedoch eine Drehbewegung des Laufrads nach Art einer "Mitnahmefunktion" auf den Sensor übertragen wird. In bevorzugter Weiterbildung ist die Drehachse des Laufrads orthogonal zu einer Fortbewegungsrichtung des Fahrzeugs orientiert. Die Steuerungseinrichtung kann eingerichtet sein, das Fahrzeug in Abhängigkeit des erstellten Abbildes autonom fortzubewegen. Alternativ oder zusätzlich kann die Steuerungseinrichtung eingerichtet sein, dass Fahrzeug anhand vorgegebener Daten, beispielsweise anhand einer elektronischen Karte, fortbewegen.

Grundsätzlich kann die Ventilationseinrichtung beliebig ausgestaltet sein. Gemäß einer bevorzugten Weiterbildung ist die Ventilationseinrichtung als Radiallüfter ausgeführt. Ebenso kann die Ventilationseinrichtung als Axialventilator ausgeführt sein. Das Laufrad weist bevorzugt Schaufeln auf, um Abwärme der Steuerungseinrichtung abzusaugen. Die Ventilationseinrichtung ist bevorzugt angeordnet und ausgestaltet, Abwärme der Steuerungseinrichtung abzusaugen und/oder Abwärme aus einer Fahrerkabine des Fahrzeugs abzusaugen. Steuerungseinrichtungen und gegebenenfalls weitere für autonomes Fahren in dem Fahrzeug vorhandene Systeme produzieren nicht selten aufgrund der für das autonome Fahren benötigten hohen Rechenleistung Abwärme von mehr als 500 W, die durch die Ventilationseinrichtung zum einwandfreien Betrieb des Fahrzeugs abzuführen ist.

Gemäß einer bevorzugten Weiterbildung ist die Ventilationseinrichtung oberhalb der Steuerungseinrichtung angeordnet und mit dieser derart verbunden, dass das Laufrad insbesondere aus einem Innenraum der Steuerungseinrichtung Luft absaugt. Ebenso kann das Laufrad Außenwärme der Steuerungseinrichtung absaugen. Bevorzugt ist die Ventilationseinrichtung berührend und/oder angrenzend oberhalb der Steuerungseinrichtung angeordnet. Weiter bevorzugt ist die Ventilationseinrichtung ausgeführt, aus der Fahrerkabine Luft abzusaugen, wodurch sich eine Klimatisierung des Fahrerhauses erreichen lässt. Ebenso kann die Ventilationseinrichtung ausgeführt sein, durch die Steuerungseinrichtung erwärmte Luft dem Fahrerhaus zum Beheizen desselben zuzuführen. Weiter bevorzugt ist die Ventilationseinrichtung ausgeführt, wahlweise dem Fahrerhaus durch die Steuerungseinrichtung erwärmte Luft zuzuführen und/oder aus dem Fahrerhaus Luft abzusaugen.

Gemäß einer anderen bevorzugten Weiterbildung ist der Sensor, die Steuerungseinrichtung und/oder die Ventilationseinrichtung an einer exponierten Position an dem Fahrzeug vorgesehen. Durch Anordnen an einer exponierten Position kann der Sensor ein möglichst weites Umfeld und damit weiträumiges Abbild der Umgebung des Fahrzeugs erfassen, so dass die Steuerungseinrichtung frühzeitig Hindernisse erkennen und/oder eine Karte der Umgebung erstellen kann. In diesem Zusammenhang ist weiter bevorzugt, dass der Sensor, die Steuerungseinrichtung und/oder die Ventilationseinrichtung an einem Dach des Fahrzeugs, insbesondere an und/oder auf einem Dach eines Fahrerhauses des Fahrzeugs, beispielsweise unter einem Windschild des Dachs, angeordnet ist. Besonders bevorzugt sind der Sensor, die Steuerungseinrichtung und die Ventilationseinrichtung übereinander auf dem Dach des Fahrerhauses und/oder einer Fahrerkabine des Fahrzeugs angeordnet. Ganz besonders bevorzugt ist der Sensor oberhalb der Ventilationseinrichtung, unmittelbar angrenzend und/oder einstückig mit dieser angeordnet.

Gemäß einer anderen bevorzugten Weiterbildung ist das Laufrad durch Fahrwind und/oder durch einen Motor antreibbar. Zum Antreiben des Laufrads durch Fahrtwind können an diesem seitliche Öffnungen vorgesehen sein, in welche der Fahrtwind einströmen und derart das Laufrad in Drehbewegung versetzen kann. Ein gegebenenfalls zusätzlicher Motor kann unterstützend und/oder bei Stillstand des Fahrzeugs zugeschaltet werden, um eine Mindestdrehzahl des Laufrads und damit Mindestkühlleistung der Ventilationseinrichtung sicherzustellen. Im Falle eines batteriebetriebenen Fahrzeugs lässt sich durch eine solche Ausgestaltung die Kühlung der Steuerungseinrichtung besonders energiesparend bewirken.

Nach einer anderen bevorzugten Weiterbildung weisen das Laufrad und der Sensor eine gemeinsame Drehachse auf. Bevorzugt ist an der gemeinsamen Drehachse eine Kupplung vorgesehen, durch welche eine Drehbewegung des Laufrads auf den Sensor übertragen wird, während der Sensor sich auch unabhängig von dem Laufrad drehen kann. Gemäß einer noch anderen bevorzugten Weiterbildung sind die Ventilationseinrichtung und der Sensor mittels eines Getriebes drehbewegungsgekoppelt. Das Getriebe weist beispielsweise ein Übersetzungsverhältnis von 2:1 oder 3:1 auf. Sofern das Laufrad zum Erzielen einer Mindestkühlung eine höhere Drehzahl als der Sensor benötigt, lässt sich diese höhere Drehzahl durch das Getriebe einstellen.

Zum Ausgestalten des Sensors existieren grundsätzlich verschiedene Möglichkeiten. Gemäß einer besonders bevorzugten Weiterbildung ist der Sensor als Lidar-Sensor ausgebildet. Ein Lidar-Sensor sendet bevorzugt Laserimpulse aus und detektiert aus der Atmosphäre zurückgestreutes Licht. Aus einer Lichtlaufzeit der Impulse wird eine Entfernung zum Ort einer Streuung berechnet und derart das Abbild der Umgebung erstellt. Ebenso kann der Lidar Sensor Laserpulse aussenden und über ein sogenanntes Time-of-Flight Verfahren einen Abstand zu einer die Laserpulse reflektierenden Oberfläche der Umgebung messen. Bevorzugt ist der Sensor als 2D-Lidar Sensor ausgebildet. Weiter bevorzugt ist der 2D-Sensor derart angeordnet, dass, bei feststehendem Sensor, durch den 2D-Sensor ein Abbild der Vertikalen, als ein zweidimensionales Abbild der Umgebung nur in Richtung der Vertikalen, erstellbar ist. Durch Drehen des 2D-Sensors um die Drehachse lässt sich in vorteilhafter Weise ein dreidimensionales Abbild der Umgebung des Fahrzeugs erstellen, ohne dass dazu ein im Vergleich zu einem 2D-Lidar Sensor ein wesentlich kostenintensiverer 3D-Lidar Sensor und derart ein wesentlich komplexerer technischer Aufbau benötigt wird.

Gemäß einer noch anderen bevorzugten Weiterbildung weist der Sensor einen gegenüber der Horizontalen verschwenkbaren Spiegel auf. Bevorzugt weist der Sensor einen Motor auf, mittels dessen der Spiegel verschwenkbar ist. Durch Verschwenken des Spiegels lässt sich ein Abbild der Vertikalen erstellen. Durch Verdrehen des Sensors und damit des Spiegels um die Drehachse, die bei gegenüber der Horizontalen unverschwenktem Fahrzeug bevorzugt in Richtung der Vertikalen verläuft, lässt sich zudem ein Abbild der Horizontalen erstellen, um im Ergebnis ein dreidimensionales Abbild der Umgebung des Fahrzeugs zu erhalten.

Die Aufgabe der Erfindung wird zudem durch ein Verfahren zum Erstellen eines Abbilds einer Umgebung eines Fahrzeugs gelöst, mit den Schritten:
Drehen eines Laufrads einer Ventilationseinrichtung, eingerichtet eine Steuerungseinrichtung des Fahrzeugs zu kühlen, und
Mitdrehen eines mit dem Laufrad drehbewegungsgekoppelten Sensors, eingerichtet das Abbild der Umgebung des Fahrzeugs zu erstellen, um eine Drehachse.

Gemäß einer bevorzugten Weiterbildung umfasst das Verfahren den Schritt:
Autonomes Fortbewegen des Fahrzeugs in Abhängigkeit des erstellten Abbilds durch die Steuerungseinrichtung.

Das vorgeschlagene Verfahren erlaubt in vorteilhafter Weise beispielsweise mittels eines 2D-Lidar Sensors ein dreidimensionales Abbild der Umgebung des Fahrzeugs zu erstellen.

Weiterbildungen des Verfahrens sowie Vorteile desselben ergeben sich für den Fachmann in Analogie zu dem zuvor beschriebenen Fahrzeug.

### Kurze Beschreibung der Zeichnungen

Nachfolgend wird die Erfindung unter Bezugnahme auf die anliegenden Zeichnungen anhand bevorzugter Ausführungsbeispiele näher erläutert.

In den Zeichnungen zeigen
- Fig. 1: eine schematische Ansicht eines Fahrzeugs gemäß einem bevorzugten Ausführungsbeispiel der Erfindung in einer Seitansicht, und
- Fig. 2: einen Ausschnitt des Fahrzeugs gemäß Fig. 1.

### Detaillierte Beschreibung der Ausführungsbespiele

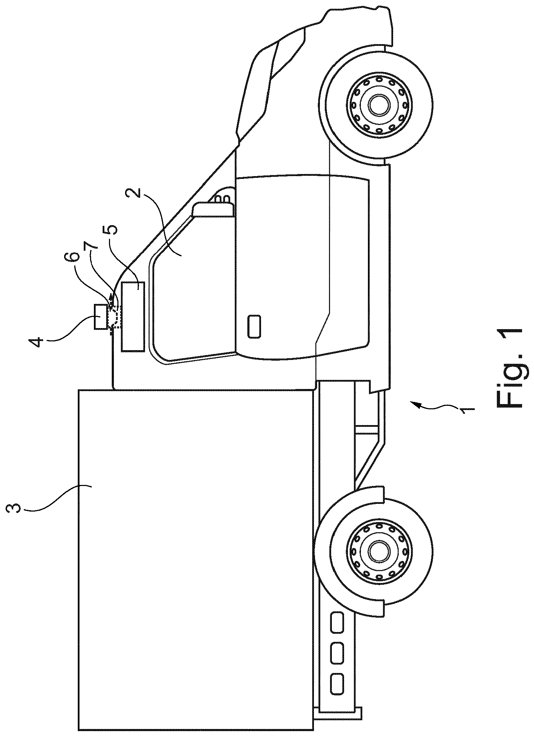

Fig. 1 zeigt ein Fahrzeug 1 gemäß einem bevorzugten Ausführungsbeispiel der Erfindung in einer schematischen Seitansicht. Das Fahrzeug 1 ist als batteriebetriebener Lieferwagen mit Fahrerkabine 2 und dahinter liegender, geschlossener Ladekabine 3 ausgeführt. Mittels des bevorzugt autonom ausgeführten Fahrzeugs 1 lassen sich Objekte unterschiedlicher Art beispielsweise zwischen einem Logistikzentrum und einem Empfänger und/oder Absender des Objektes gänzlich ohne menschliche Interaktion überbringen.

Zum Erzeugen eines Abbildes einer Umgebung des Fahrzeugs 1 weist das Fahrzeug 1 einen als 2D-Lidar Sensor ausgebildeten Sensor 4 auf, der an einer exponierten Position an dem Fahrzeug 1 vorliegend auf einem Dach der Fahrerkabine 2 angeordnet und um eine sich orthogonal zu einer Ladefläche und/oder Fortbewegungsrichtung des Fahrzeugs 1 erstreckende Sensordrehachse drehbar gelagert ist. Derart hat der Sensor 4 einen nur rückwärtig durch die Ladekabine 3 begrenzten Rundumblick. Der Lidar-Sensor 4 sendet Laserpulse aus und misst mittels eines sogenannten Time-of-Flight Verfahrens einen Abstand zu einer die Laserpulse reflektierenden Oberfläche der Umgebung, um derart das Abbild der Umgebung zu erstellen.

Das Fahrzeug 1 weist ferner eine computerbasierte Steuerungseinrichtung 5 auf, welche eingerichtet ist, das Fahrzeug 1 aufgrund des durch den Sensor 4 erhaltenen Abbilds autonom entlang einer festgelegten oder dynamisch bestimmten Route fortzubewegen. Die Steuerungseinrichtung 5 kann weitere elektrische Komponenten zum autonomen Steuern des Fahrzeugs 1 aufweisen. Die Steuerungseinrichtung 5 ist ebenso auf dem Dach der Fahrerkabine 2 angeordnet.

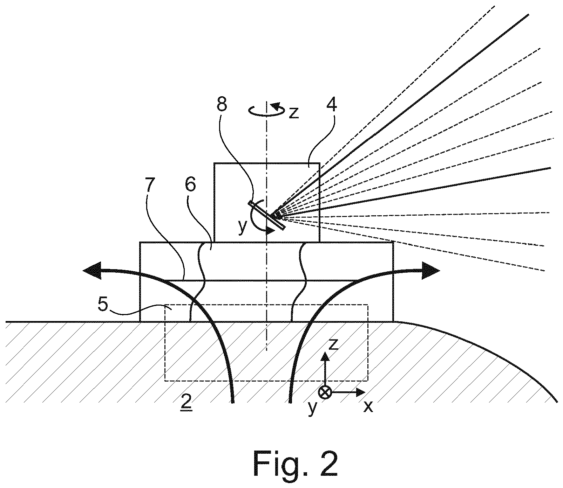

Um Abwärme der Steuerungseinrichtung 5 von nicht selten mehr als 500 W abzuführen, ist ferner eine Ventilationseinrichtung 6 in Form eines Radiallüfters vorgesehen, welche ein drehbar gelagertes Laufrad 7 aufweist, angedeutet in Fig. 1. Eine Drehachse des Laufrads 7 ist orthogonal zu der Ladefläche bzw. der Fortbewegungsrichtung des Fahrzeugs 1 orientiert ist. Die Steuerungseinrichtung 5 ist unmittelbar berührend auf dem Dach der Fahrerkabine 2 angeordnet, so dass durch das Laufrad 7 Abwärme aus einem Innenraum der Steuerungseinrichtung 5 absaugbar ist, angedeutet durch einen Pfeil. Berührend auf der Steuerungseinrichtung 5 ist beabstandet von dem Dach zunächst die Ventilationseinrichtung 6 und in der Folge am höchsten Punkt über dem Dach der Sensor 4 angeordnet. Fig. 2 zeigt die Anordnung von Dach der Fahrerkabine 2, Steuerungseinrichtung 5, Ventilationseinrichtung 6 mit Laufrad 7 und Sensor 4 im Detail.

Sensor 4 und Laufrad 7 sind drehbewegungsgekoppelt derart miteinander verbunden, dass das Laufrad 7 bei einer Drehbewegung den Sensor 4 um die Drehachse mitdreht. Dazu weisen Sensor 4 und Laufrad 7 eine dreh gekoppelte gemeinsame Achse derart auf, dass einerseits das durch Fahrwind oder durch einen innerhalb der Ventilationseinrichtung 6 vorgesehenen Motor angetriebene Laufrad 7 eine Drehbewegung des Laufrads 7 auf den Sensor 4 überträgt. Drehachse des Laufrads 7 und Sensordrehachse des Sensors 4 stimmen überein und sind durch zwei ineinanderlaufende Wellen und/oder über ein Getriebe miteinander drehbewegungsgekoppelt verbunden.

Ebenso kann der Sensor 4 einen eigenen Motor aufweisen, um den Sensor 4 um die Sensordrehachse zu drehen. Da der Sensor 4 derart durch das Laufrad 7 drehbar ist, lässt sich durch die vorgeschlagene Lösung ein 2D-Lidar 4 in einfacher Weise zum einem 3D-Lidar 4 aufwerten: Durch die von dem Laufrad 7 auf den Sensor 4 übertragene Drehbewegung dreht sich der Sensor 4 um die Sensordrehachse. Sofern nun beispielsweise ein 2D-Lidar 4 orthogonal verschwenkt auf der Ventilationseinrichtung 6 angeordnet wird, welcher ohne Drehbewegung durch einen an dem Sensor 4 vorgesehenen gegenüber der Horizontalen verschwenkbaren Spiegel 8 nur ein zweidimensionales Abbild einer Ebene parallel zu der Vertikalen aufnehmen würde, führt eine aufgrund der Bewegungskopplung durch das Laufrad auf den Sensor 4 übertragene Drehbewegung um die Drehachse dazu, dass durch den 2D-Lidar 4 ein dreidimensionales Abbildung der Umgebung erfassbar ist. Bezugnehmend auf Fig. 2 wird der Spiegel 8 einerseits durch die Drehbewegungskoppelung um die in der Fig. 2 als Z-Achse bezeichnete Sensordrehachse verdreht und andererseits durch einen Motor des Sensors 4 um die Y-Achse verschwenkt.

**Bezugszeichenliste**

| | |
|---|---|
| Fahrzeug | 1 |
| Fahrerkabine | 2 |
| Ladekabine | 3 |
| Sensor | 4 |
| Steuerungseinrichtung | 5 |
| Ventilationseinrichtung | 6 |
| Laufrad | 7 |
| Spiegel | 8 |

## Patentansprüche

1. Fahrzeug (1) mit
einem drehbar gelagerten Sensor (4), eingerichtet ein Abbild einer Umgebung des Fahrzeugs (1) zu erstellen,
einer Steuerungseinrichtung (5), eingerichtet von dem Sensor (4) erhaltene Daten zu verarbeiten und weiterhin eingerichtet, das Fahrzeug (1) autonom fortzubewegen, anhand von dem Sensor (4) erhaltenen Umgebungsdaten das Abbild der Umgebung zu berechnen und/oder das Fahrzeug (1) in Abhängigkeit des erstellten Abbilds autonom fortzubewegen,
einer Ventilationseinrichtung (6), die mit dem Sensor (4) derart drehbewegungsgekoppelt ist, dass ein drehbar gelagertes Laufrad (7) den Sensor (4) um eine Drehachse mitdreht,
**dadurch gekennzeichnet, dass**
die Ventilationseinrichtung (6) zum Kühlen der Steuerungseinrichtung (5) mittels des drehbar gelagerten Laufrads (7) eingerichtet ist, wobei das Laufrad (7) Abwärme einer für solche Steuerungs- und/oder Rechenaufgaben notwendigen Rechenleistung der Steuerungseinrichtung (5) abführt, die benötigt werden, um das Fahrzeug (1) autonom fortzubewegen, das Abbild der Umgebung anhand der von dem Sensor erhaltenen Umgebungsdaten zu berechnen und/oder das Fahrzeug in Abhängigkeit des erstellten Abbilds autonom fortzubewegen.

2. Fahrzeug (1) nach dem vorhergehenden Anspruch, wobei die Drehachse des Laufrads (2) orthogonal zu einer Fortbewegungsrichtung des Fahrzeugs (1) orientiert ist.

3. Fahrzeug (1) nach einem der vorhergehenden Ansprüche, wobei die Ventilationseinrichtung (6) als Radiallüfter ausgeführt ist.

4. Fahrzeug (1) nach einem der vorhergehenden Ansprüche, wobei die Ventilationseinrichtung (1) oberhalb der Steuerungseinrichtung (5) angeordnet und mit dieser derart verbunden ist, dass das Laufrad (7) insbesondere aus einem Innenraum der Steuerungseinrichtung (5) Luft absaugt.

5. Fahrzeug (1) nach einem der vorhergehenden Ansprüche, wobei der Sensor (4), die Steuerungseinrichtung (5) und/oder die Ventilationseinrichtung (6) an einer exponierten Position an dem Fahrzeug (1) vorgesehen ist.

6. Fahrzeug (1) nach einem der vorhergehenden Ansprüche, wobei der Sensor (4), die Steuerungseinrichtung (5) und/oder die Ventilationseinrichtung (6) an einem Dach des Fahrzeugs (1), insbesondere an einem Dach einer Fahrerkabine (2) des Fahrzeugs (1), angeordnet ist.

7. Fahrzeug (2) nach einem der vorhergehenden Ansprüche, wobei der Sensor (4) oberhalb der Ventilationseinrichtung (6) angeordnet ist.

8. Fahrzeug (1) nach einem der vorhergehenden Ansprüche, wobei das Laufrad (7) durch Fahrwind und/oder durch einen Motor antreibbar ist.

9. Fahrzeug (1) nach einem der vorhergehenden Ansprüche, wobei das Laufrad und der Sensor eine gemeinsame Drehachse aufweisen.

10. Fahrzeug (1) nach einem der vorhergehenden Ansprüche, wobei die Ventilationseinrichtung (6) und der Sensor (4) mittels eines Getriebes drehbewegungsgekoppelt sind.

11. Fahrzeug (1) nach einem der vorhergehenden Ansprüche, wobei der Sensor (4) als Lidar-Sensor ausgebildet ist

12. Fahrzeug (1) nach einem der vorhergehenden Ansprüche, wobei der Sensor (4) einen gegenüber der Horizontalen verschwenkbaren Spiegel (8) aufweist.

13. Verfahren zum Erstellen eines Abbilds einer Umgebung eines einen drehbar gelagerten Sensor (4), eine Steuerungseinrichtung (5) und eine Ventilationseinrichtung (6) aufweisenden Fahrzeugs (1) nach einem der Ansprüche 1 bis 12, mit den Schritten:
Drehen eines Laufrads (2) der Ventilationseinrichtung (6), eingerichtet die Steuerungseinrichtung (5) zu kühlen, und
Mitdrehen des mit dem Laufrad (2) drehbewegungsgekoppelten Sensors (4), eingerichtet das Abbild der Umgebung des Fahrzeugs (1) zu erstellen, um eine Drehachse.

14. Verfahren nach dem vorherigen Anspruch, mit dem Schritt:
Autonomes Fortbewegen des Fahrzeugs (1) in Abhängigkeit des erstellten Abbilds durch die Steuerungseinrichtung (5).

## Claims

1. Vehicle (1) with
a rotatably mounted sensor (4) designed to produce an image of an environment of the vehicle (1),
a control device (5) designed to process data received from the sensor (4) and also designed to move the vehicle (1) autonomously, to calculate the image of the environment on the basis of environment data obtained from the sensor (4) and/or to move the vehicle (1) autonomously in dependence on the image produced,
a ventilation device (6), which is rotationally coupled to the sensor (4) in such a way that a rotatably mounted impeller (7) rotates the sensor (4) about an axis of rotation,
**characterized in that**
the ventilation device (6) is designed for cooling the control device (5) by means of the rotatably mounted impeller (7), the impeller (7) removing waste heat attributable to computing power of the control device (5) necessary for such control and/or computing tasks that are required in order to move the vehicle (1) autonomously, calculate the image of the environment on the basis of the environment data obtained from the sensor and/or to move the vehicle autonomously in dependence on the image produced.

2. Vehicle (1) according to the preceding claim, wherein the axis of rotation of the impeller (2) is oriented orthogonally to a direction of movement of the vehicle (1) .

3. Vehicle (1) according to one of the preceding claims, wherein the ventilation device (6) is designed as a radial fan.

4. Vehicle (1) according to one of the preceding claims, wherein the ventilation device (1) is disposed above the control device (5) and is connected to the control device (5) in such a way that the impeller (7) extracts air in particular from an interior space of the control device (5) .

5. Vehicle (1) according to one of the preceding claims, wherein the sensor (4), the control device (5) and/or the ventilation device (6) is/are provided at an exposed position on the vehicle (1).

6. Vehicle (1) according to one of the preceding claims, wherein the sensor (4), the control device (5) and/or the ventilation device (6) is/are disposed on a roof of the vehicle (1), in particular on a roof of a driver's cab (2) of the vehicle (1).

7. Vehicle (2) according to one of the preceding claims, wherein the sensor (4) is disposed above the ventilation device (6) .

8. Vehicle (1) according to one of the preceding claims, wherein the impeller (7) can be driven by relative wind and/or by a motor.

9. Vehicle (1) according to one of the preceding claims, wherein the impeller and the sensor have a common axis of rotation.

10. Vehicle (1) according to one of the preceding claims, wherein the ventilation device (6) and the sensor (4) are rotationally coupled by means of a gear mechanism.

11. Vehicle (1) according to one of the preceding claims, wherein the sensor (4) is formed as a lidar sensor.

12. Vehicle (1) according to one of the preceding claims, wherein the sensor (4) comprises a mirror (8) that is pivotable relative to the horizontal.

13. Method for producing an image of an environment of a vehicle (1) having a rotatably mounted sensor (4), a control device (5) and a ventilation device (6) according to one of Claims 1 to 12, with the steps of:
turning an impeller (2) of a ventilation device (6) designed to cool the control device (5) and
rotating about an axis of rotation the sensor (4) that is rotationally coupled to the impeller (2) and that is designed to produce the image of the environment of the vehicle (1).

14. Method according to the preceding claim, with the step of:
autonomously moving the vehicle (1) in dependence on the image produced by the control device (5).

## Revendications

1. Véhicule (1), comprenant
un capteur (4) monté rotatif, conçu pour créer une image d'un environnement du véhicule (1),
un dispositif de commande (5) conçu pour traiter des données reçues du capteur (4) et en outre conçu pour déplacer le véhicule (1) de manière autonome, pour calculer l'image de l'environnement à l'aide de données d'environnement reçues du capteur (4), et/ou pour déplacer le véhicule (1) de manière autonome en fonction de l'image créée,
un dispositif de ventilation (6) qui est couplé en rotation avec le capteur (4) de telle sorte qu'un rotor (7) monté rotatif entraîne le capteur (4) en rotation autour d'un axe de rotation,
**caractérisé en ce que**
le dispositif de ventilation (6) est conçu pour refroidir le dispositif de commande (5) au moyen du rotor (7) monté rotatif, le rotor (7) évacuant la chaleur dissipée d'une puissance de calcul du dispositif de commande (5) nécessaire à de telles opérations de commande et/ou de calcul, qui sont nécessaires pour déplacer le véhicule (1) de manière autonome, pour calculer l'image de l'environnement à l'aide des données d'environnement obtenues du capteur, et/ou pour déplacer le véhicule de manière autonome en fonction de l'image créée.

2. Véhicule (1) selon la revendication précédente, dans lequel l'axe de rotation du rotor (2) est orienté de manière orthogonale à une direction de déplacement du véhicule (1).

3. Véhicule (1) selon l'une quelconque des revendications précédentes, dans lequel le dispositif de ventilation (6) est réalisé sous la forme d'un ventilateur radial.

4. Véhicule (1) selon l'une quelconque des revendications précédentes, dans lequel le dispositif de ventilation (1) est disposé au-dessus du dispositif de commande (5) et est relié à celui-ci de telle sorte que le rotor (7) aspire de l'air en particulier à partir d'un espace intérieur du dispositif de commande (5).

5. Véhicule (1) selon l'une quelconque des revendications précédentes, dans lequel le capteur (4), le dispositif de commande (5) et/ou le dispositif de ventilation (6) sont prévus dans une position exposée sur le véhicule (1).

6. Véhicule (1) selon l'une quelconque des revendications précédentes, dans lequel le capteur (4), le dispositif de commande (5) et/ou le dispositif de ventilation (6) sont disposés sur un toit du véhicule (1), en particulier sur un toit d'une cabine de conducteur (2) du véhicule (1).

7. Véhicule (2) selon l'une quelconque des revendications précédentes, dans lequel le capteur (4) est disposé au-dessus du dispositif de ventilation (6).

8. Véhicule (1) selon l'une quelconque des revendications précédentes, dans lequel le rotor (7) peut être entraîné par le vent relatif et/ou par un moteur.

9. Véhicule (1) selon l'une quelconque des revendications précédentes, dans lequel le rotor et le capteur présentent un axe de rotation commun.

10. Véhicule (1) selon l'une quelconque des revendications précédentes, dans lequel le dispositif de ventilation (6) et le capteur (4) sont couplés en rotation au moyen d'un mécanisme de transmission.

11. Véhicule (1) selon l'une quelconque des revendications précédentes, dans lequel le capteur (4) est réalisé sous la forme de capteur lidar.

12. Véhicule (1) selon l'une quelconque des revendications précédentes, dans lequel le capteur (4) présente un miroir (8) pivotant par rapport à l'horizontale.

13. Procédé permettant de créer une image d'un environnement d'un véhicule (1) présentant un capteur (4) monté rotatif, un dispositif de commande (5) et un dispositif de ventilation (6) le selon l'une quelconque des revendications 1 à 12, comprenant les étapes consistant à :
faire tourner un rotor (2) du dispositif de ventilation (6), conçu pour refroidir le dispositif de commande (5), et
entraîner en rotation autour d'un axe de rotation le capteur (4) couplé en rotation avec le rotor (2), conçu pour créer l'image de l'environnement du véhicule (1) .

14. Procédé selon la revendication précédente, comprenant l'étape consistant à :
déplacer le véhicule (1) de manière autonome en fonction de l'image créée par le dispositif de commande (5) .
